# EUROPEAN PATENT APPLICATION

(11) **EP 0 544 164 A1**
(43) Date of publication of application: **02.06.1993**
(21) Application number: 92119462.7
(22) Date of filing: 13.11.1992
(51) Int. Cl.: G06F 1/10, G06F 15/60

(54) **Semi custom-made integrated circuit having clock synchronous circuit improved in clock skew**

(30) Priority: 26.11.1991 JP 336346/91
(71) Applicant: NEC CORPORATION, Tokyo (JP)
(72) Inventor: Okamura, Hitoshi, c/o NEC Corporation, Minato-ku, Tokyo (JP)
(74) Representative: Glawe, Delfs, Moll & Partner

(57) **Abstract**

A clock synchronous circuit is incorporated in a semicustom-made integral circuit fabricated through an application specific integral circuit design technology, and comprises a main buffer circuit (22a) supplying a clock signal therefrom, a plurality of first-level sub buffer circuits (22b/ 22c) for relaying said clock signal, a second-stage of sub buffer circuits (22d/ 22e/ 22f/ 22g) for relaying said clock signal to internal circuits (25), and a wiring network (24) coupled from said main buffer circuit through said plurality of first-level sub buffer circuits and said second-stage of sub buffer circuits with said internal circuits and arranged in such a manner that signal paths from said main buffer circuit to said final-stage of sub buffer circuits are approximately equal to one another, wherein the clock synchronous circuit serves as an electrically and geometrically independent unit in a design work so as to minimize clock skew without sacrifice of design flexibility.

## Description

### FIELD OF THE INVENTION

This invention relates to a semicustom-made semiconductor integrated circuit device and, more particularly, to a semicustom-made semiconductor integrated circuit device containing a clock synchronous circuit.

### DESCRIPTION OF THE RELATED ART

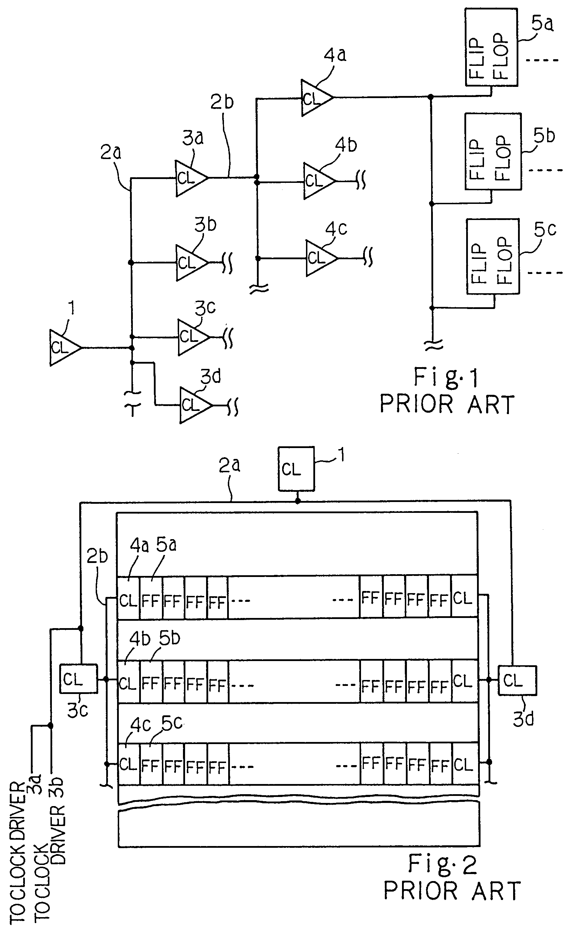

A typical example of a clock synchronous circuit incorporated in a semiconductor integrated circuit is illustrated in Fig. 1, and is arranged in tree-like scheme. Namely, a main clock driver circuit 1 is coupled with a wiring 2a, and the wiring 2a is branched into more than four so that at least four first-stage sub clock drivers 3a, 3b 3c and 3d are coupled therewith. Each of the first-stage sub clock drivers 3a to 3d are coupled with second-stage sub clock drivers in a similar manner. For example, the first-stage sub clock driver 3a is coupled with a wiring 2b, and the wiring 2b is branched into more than three. At least three second-stage sub clock drivers 4a, 4b and 4c are coupled with the wiring 2b. All of the second-stage sub clock drivers including the drivers 4a to 4c are coupled with flip flop circuits including flip flop circuits 5a, 5b and 5c, and the clock synchronous circuit thus arranged supplies a clock signal to the flip flop circuits.

When the prior art clock synchronous circuit is fabricated from circuit components already incorporated in a master slice, the main clock driver 1, the first-stage sub clock drivers 3a to 3c, the second-stage sub clock drivers 4a to 4c and the flip flop circuits 5a to 5c are formed in previously assigned areas, and are arranged as shown in Fig. 2. The wirings 2a and 2b are tailored for the tree-like scheme, and the signal paths from the main clock driver 1 through the first-stage sub clock drivers 3a to 3d to the second-stage sub clock drivers such as 4a to 4c can be regulated to be equal in length. If the signal paths are equal in length to one another, any clock skew takes place. However, it is necessary to tailor the wirings 2a and 2b, and the tree-like scheme is hardly applicable to another semicustom-made semiconductor integrated circuit device.

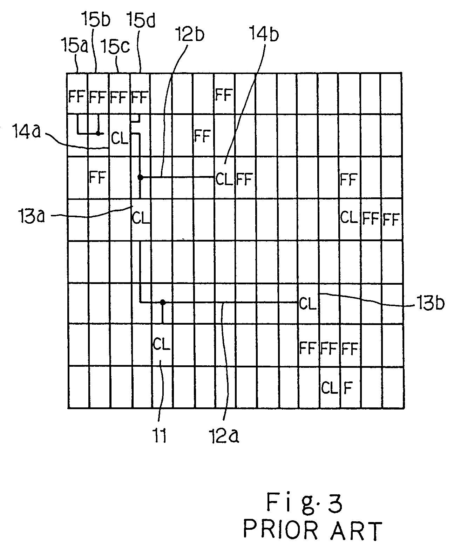

Fig. 3 shows the arrangement of another prior art clock synchronous circuit incorporated in a semicustom-made integrated circuit designed through a standard cell technology. The clock synchronous circuit has a main clock driver 11 coupled through a bifurcated wiring 12a with first-stage sub clock drivers 13a and 13b, and the first-stage sub clock driver 13a is coupled through a bifurcated wiring 12b with second-stage sub clock drivers 14a and 14b. The second-stage clock driver 14a distributes a clock signal to flip flop circuits 15a, 15b, 15c and 15d. The other clock drivers and the other flip flop circuits are labeled with "CL" and "FF", respectively. According to the standard cell technology, design flexibility is enhanced. However, detailed wiring arrangement is hardly taken into account of. For this reason, the output node of the main clock driver 1 tends to be closer to the input node of the first-level sub clock drivers 3c or 3d rather than the input nodes of the other first-level sub clock drivers 3a and 3b, and the output node of the first stage sub clock driver 3a tends to be closer to the input node of the second-stage sub-clock driver 4b rather than the input noes of the other second-stage sub clock drivers 4a and 4c. As a result, the signal paths from the main clock driver 1 through the first-level sub clock drivers 3a to 3d to the second- level sub clock drivers such as 4a to 4c are different in length from one another, and undesirable clock skew is much liable to take place.

The signal path from the main clock driver 11 to the first-stage sub clock driver 13a is different in length from the signal path from the main clock driver 11 to the first-stage sub clock driver 13b, and the signal path from the first-stage sub clock driver 13a to the second-stage sub clock driver 14a is different in length from the signal path between the first-stage sub clock driver 13a and the second-stage sub clock driver 14b.

As described hereinbefore, when the clock drivers and the wirings are formed in the areas already assigned, it is relatively easy to optimize the clock tree scheme, and clock skew is minimized. However, a problem is encountered in the design flexibility. On the other hand, if the clock synchronous circuit is realized through a standard cell design technology without any previously assigned area, the design flexibility is enhanced. However, it is difficult to minimize the clock skew.

### SUMMARY OF THE INVENTION

It is therefore an important object of the present invention to provide a semicustom-made semiconductor integrated circuit device comprising a clock synchronous circuit block which is improved in clock skew.

To accomplish the object, the present invention proposes to previously construct a clock synchronous circuit block arranged in such a manner that signal paths from a main clock buffer circuit to final-stage clock buffer circuits are equal in length to one another. In the design work for a semicustom-made semiconductor integrated circuit device, the clock synchronous circuit block is treated as an electrically and geometrically independent unit.

In accordance with the present invention, there is provided a semicustom-made integrated circuit having a clock synchronous circuit block fabricated from component cells in an internal cell array area and serving as an electrically and geometrically independent unit in a design work, the clock synchronous circuit comprising: a) a main buffer circuit supplying a clock signal therefrom; b) a plurality of first-level sub buffer circuits for relaying the clock signal; c) a plurality of final-stage of sub buffer circuits for relaying the clock signal to internal circuits; and d) a wiring network coupled from the main buffer circuit through the plurality of first-level sub buffer circuits and the plurality of final-stage of sub buffer circuits with the internal circuits, and arranged in such a manner that signal paths from the main buffer circuit to the final-stage of sub buffer circuits are approximately equal to one another for eliminating clock skew without design flexibility.

### BRIEF DESCRIPTION OF THE DRAWINGS

The features and advantages of the semicustom-made integrated circuit according to the present invention will be more clearly understood from the following description taken in conjunction with the accompanying drawings in which:
Fig. 1 is a circuit diagram showing the circuit arrangement of the prior art clock synchronous circuit;
Fig. 2 is a view showing the layout of the prior art clock synchronous circuit;
Fig. 3 is a view showing the layout of another prior art clock synchronous circuit;
Fig. 4 is a view showing the layout of a clock synchronous circuit according to the present invention; and
Fig. 5 is a circuit diagram showing the arrangement of another clock synchronous circuit according to the present invention.

### DESCRIPTION OF THE PREFERRED EMBODIMENTS

### First Embodiment

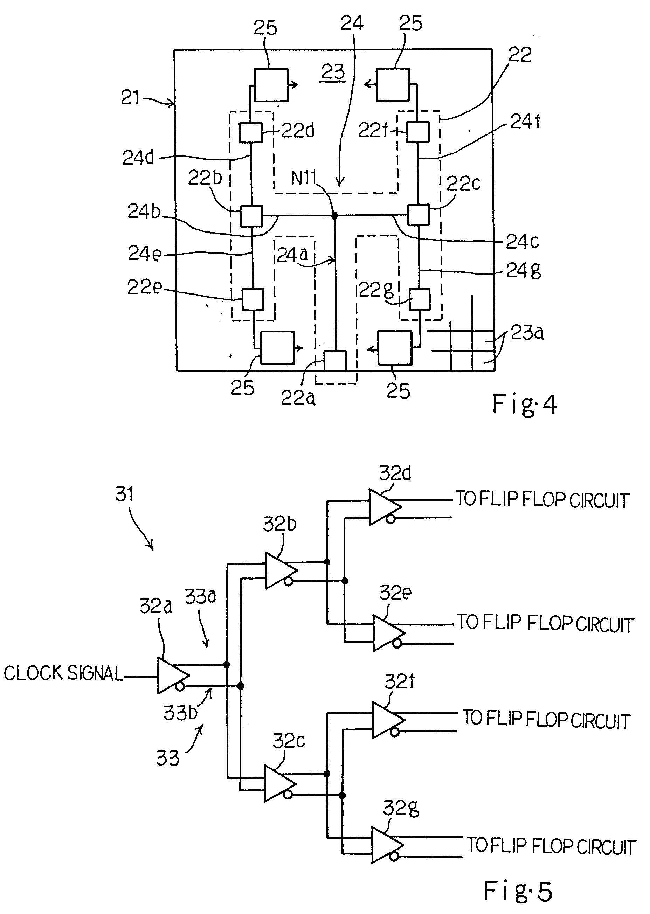

Referring to Fig. 4 of the drawings, a semicustom-made integrated circuit 21 embodying the present invention is fabricated through an ASIC (Application Specific Integral Circuit) design technology, and comprises a clock tree block 22 implementing a clock synchronous circuit. The clock tree block 22 is integrated in an internal cell array area 23 serving as an electrically and geometrically independent unit to other parts of the semicustom-made integrated circuit 21 in a design work, and is fabricated from component cells 23a arranged in array in the internal cell array area 23. The clock tree block 22 comprises a plurality of clock buffer circuits 22a to 22g, and a wiring arrangement 24. The plurality of clock buffer circuits 22a to 22g are arranged in hierarchical system, and are substantially identical in characteristics with one another. However, in another implementation, the plurality of clock buffer circuits 22b to 22g except for the clock buffer circuit 22a may be identical in characteristics with one another. The semicustom-made integrated circuit further comprises a plurality of flip flop circuits 25 driven by the clock synchronous circuit, and are fabricated from component cells forming other part of the internal cell array area 23. In this instance, the flip flop circuits 25 serve as internal circuits.

The clock buffer circuit 22a serves as a main clock buffer circuit, and is coupled through a first wiring 24a with the clock buffer circuits 22b and 22c serving as first-stage sub clock buffer circuits. The first wiring 24a is bifurcated, and is symmetrical with respect to the clock buffer circuit 22a. In detail, a wiring strip extends from the output node of the clock buffer circuit 22a to a node N11, and is shared between signal paths from the clock buffer circuit 22a to the respective clock buffer circuits 22b and 22c. The node N11 is coupled through wiring strips 24b and 24c with the input nodes of the clock buffer circuits 22b and 22c, and the wiring strips 24b and 24c are equal in length. Therefore, the signal path from the clock buffer circuit 22a to the clock buffer circuit 22b is equal in length to the signal path from the clock buffer circuit 22a to the clock buffer circuit 22c.

The clock buffer circuit 22b is coupled through wiring strings 24d and 24e with the clock buffer circuits 22d and 22e serving as second-stage sub clock buffer circuits, and the wiring strips 24d and 24e are equal in length to each other. In other words, the signal path from the clock buffer circuit 22b to the clock buffer circuit 22d is equal in length to the signal path from the clock buffer circuit 22b to the clock buffer circuit 22e. As a result, signal path from the clock buffer circuit 22a to the clock buffer circuit 22d is equal in length to signal path from the clock buffer circuit 22a to the clock buffer circuit 22e.

In the similar manner, the clock buffer circuit 22c is coupled through wiring strings 24f and 24g with the clock buffer circuits 22f and 22g serving as other second-stage sub clock buffer circuits, and the wiring strips 24f and 24g are equal in length to each other as well as to the wiring strips 24d and 24e. In other words, the signal path from the clock buffer circuit 22c to the clock buffer circuit 22f is equal in length to the signal path from the clock buffer circuit 22c to the clock buffer circuit 22g as well as the signal paths between the clock buffer circuit 22b and the clock buffer circuits 22d and 22e. As a result, signal path from the clock buffer circuit 22a to the clock buffer circuit 22f is equal in length to signal path from the clock buffer circuit 22a to the clock buffer circuit 22g as well as to the signal paths between the clock buffer circuit 22a to the clock buffer circuits 22d and 22e.

The clock synchronous circuit thus arranged distributes a single-phase clock signal to the flip flop circuits 25, and, accordingly, drives the flip flop circuits 25.

Description is made on a design work on the semicustom-made integrated circuit according to the present invention. In the following description, words "ASIC Design Technology" mean a design work on a substrate having circuit devices with electrical characteristics and geometrical properties for achieving a predetermined function through arrangement of a wiring network in consultation with a data base storing the electrical characteristics and the geometrical properties. Typical design technologies of the ASIC are called as a master slice design technology and a standard cell design technology. According to the master slice design technology, a semiconductor fabrication sequence is carried out on semiconductor wafers for circuit components, and each semiconductor wafer is broken down into a large number of semiconductor chips after completion of wiring arrangement at later stage, and the design work traces a sequence where one of a plurality of standard circuit devices are selected from a library of electrical and geometrical data base, then arranging the standard circuit devices on a semiconductor chip, arranging a wiring network for interconnection, thereby accelerating the design work. Since the wiring arrangement is tailored in accordance with a design specification for a semicustom-made integrated circuit, and the semiconductor chips may achieve different logical function from those arranged in accordance with another design specification. The standard cell design technology allows a circuit designer to select circuit components from various circuit components already stored in a library, and the selected circuit components are integrated so as to achieve a logical function requested by a customer.

According to the present invention, a semicustom-made integrated circuit device is designed in such a manner that a clock synchronous circuit already designed for minimizing clock skew is assumed to be an available unit in the ASIC design work. Therefore, the clock synchronous circuit is registered in the electrical and geometrical data base as one of the function blocks together with circuit components and other function blocks.

The electrical and geometrical data base is shared between not only the semicustom-made integrated circuit shown in Fig. 4 but also other semicustom-made integrated circuits different in design specification, and contains electrical and geometrical data of various function blocks. The electrical data base contains input and output signal levels, component cells forming each function block, delay time between input nodes and output nodes of each function block, description on circuit behavior and so fourth, and the geometrical data base is constituted by locations of the input and output nodes of each function block, wiring strips available for a wiring network incorporated in each function block and so forth. For the clock tree block 22, the same electrical and geometrical data such as, for example, delay time from the clock buffer circuit 22a to the clock buffer circuits 22d to 22g, the function and informative data for available wiring strips are previously prepared, and are stored in the electrical and geometrical data base, and, for this reason, the clock tree block 22 according to the present invention is of the affinity to the electrical and geometrical data base already established.

The design work on the semicustom-made integrated circuit shown in Fig. 4 starts with preparation of a design specification, and electrical and geometrical data of various clock tree blocks have been already stored in the electrical and geometrical data base together with electrical and geometrical data of various function blocks available for semicustom-made integrated circuits. Of course, the electrical and geometrical data of the flip flop circuit 25 are incorporated in the electrical and geometrical data base. The electrical data are linked with the geometrical data for each function block, and a designer can simultaneously refer to both electrical and geometrical data.

A circuit designer accesses the electrical and geometrical data base with a design tool such as a CAD (Computer Aided Design) system. If a semicustom-made integrated circuit is designed through the ASIC design technology classified into the master slice technology, the clock synchronous circuit block has been already fabricated on a semiconductor chip together with other components, and the designer arranges a wiring network between the clock synchronous circuit blocks and between the clock synchronous circuit block and the other components depending upon the electrical characteristics and the geometrical properties in consultation with the data base.

On the other hand, if a semicustom-made integrated circuit device is designed through the ASIC design technology classified into the ASIC design technology classified into the standard cell technology, a designer selects the clock synchronous circuit as a system component, and arranges the location and the wiring network together with other clock synchronous circuit blocks depending upon the electrical characteristics and the geometrical properties.

Thus, the semicustom-made integrated circuit device according to the present invention is designed by using the clock synchronous circuit as an electrically and geometrically independent unit, and clock skew is minimized without sacrifice of design flexibility.

### Second Embodiment

Turning to Fig. 5 of the drawings, a clock tree block 31 embodying the present invention is fabricated from complementary clock buffer circuits 32a to 32g hierarchically coupled through a wiring network 33, and the complementary clock buffer circuits 32a to 32g are identical in characteristics with one another. The clock tree block 31 serves as a clock synchronous circuit, and wiring arrangement is doubled for a two-phase clock signal. The clock buffer circuit 32a serves as a main clock buffer circuit, and the clock buffer circuits 32b and 32c serve as first-stage sub clock buffer circuits. The clock buffer circuits 32d to 32g serve as second-stage sub clock buffer circuits. The wiring network 33 has a first wiring arrangement 33a assigned to an in-phase clock signal, and a second wiring arrangement 33b is assigned to a complementary clock signal. The first wiring arrangement 33a is partially in symmetrical with respect to the clock buffer circuit 32a and partially in symmetrical with respect to the clock buffer circuit 32b. Similarly, the second wiring arrangement 33b is partially in symmetrical with respect to the clock buffer circuit 32a and partially symmetrical with respect to the clock buffer circuit 32c. For this reason, time delay from the clock buffer circuit 32a to one of the clock buffer circuits 32d to 32g is equal to time delay to another clock buffer circuit 32e, 32f or 32g, and clock skew is effectively decreased.

In this instance, the clock synchronous circuit is improved in resistance against noises rather than the first embodiment, because the complementary clock signal is used for driving the clock synchronous circuit.

Although particular embodiments of the present invention have been shown and described, it will be obvious to those skilled in the art that various changes and modifications may be made without departing from the spirit and scope of the present invention. For example, the clock tree block according to the present invention may be associated with various internal circuits driven by a single-phase or two-phase clock signal.

## Claims

1. A semicustom-made integrated circuit having a clock synchronous circuit (22; 31) fabricated from component cells (23a) in an internal cell array area (23), said clock synchronous circuit comprising:
a) a main buffer circuit (22a; 32a) supplying a clock signal therefrom;
b) a plurality of first-level sub buffer circuits (22b/ 22c; 32b/ 32c) for relaying said clock signal;
c) a plurality of final-stage of sub buffer circuits (22d/ 22e/ 22f/ 22g; 32d/ 32e/ 32f/ 32g) for relaying said clock signal to internal circuits (25); and
d) a wiring network (24; 33) coupled from said main buffer circuit through said plurality of first-level sub buffer circuits and said plurality of final-stage of sub buffer circuits with said internal circuits,
characterized in that
said wiring network is arranged in such a manner that signal paths from said main buffer circuit to said final-stage of sub buffer circuits are approximately equal to one another for eliminating clock skew, said clock synchronous circuit coupled through said wiring network serving as an electrically and geometrically independent unit in a design work for said semicustom-made integrated circuit.

2. A semicustom-made integrated circuit as set forth in claim 1, in which said application specific integral circuit design technology is applied to a master slice.

3. A semicustom-made integrated circuit as set forth in claim 1, in which said application specific integral circuit design technology is applied to a standard cell.

4. A semicustom-made integrated circuit as set forth in claim 1, in which said signal paths (24a/ 24b/ 24d; 24a/ 24b/ 24e; 24a/ 24c/ 24f; 24a/ 24c/ 24g) are equal in length to one another, and at least said plurality of first-stage of sub buffer circuits (22b/ 22c) and said plurality of final-stage of sub buffer circuits (22d/ 22e/ 22f/ 22g) are identical in characteristics with one another, thereby introducing predetermined time delay from said main buffer circuit to said plurality of final-stage of sub buffer circuits.

5. A semicustom-made integrated circuit as set forth in claim 1, in which said clock signal is constituted by a first-phase clock train and a second-phase clock train complementary to said first-phase clock train.
